# EUROPEAN PATENT SPECIFICATION

(11) **EP 3 114 248 B1**
(45) Date of publication and mention of the grant of the patent: **07.05.2025**
(21) Application number: 14884332.9
(22) Date of filing: 04.03.2014
(51) Int. Cl.: H01L 21/20, H01L 21/02, C23C 16/18, C23C 16/455, C23C 16/22, C23C 16/40

(54) **ATOMIC LAYER DEPOSITION OF GERMANIUM OR GERMANIUM OXIDE**
ATOMLAGENABSCHEIDUNG VON GERMANIUM ODER GERMANIUMOXID
DEPOT DE COUCHES ATOMIQUES DE GERMANIUM OU D'OXYDE DE GERMANIUM

(43) Date of publication of application: 11.01.2017
(73) Proprietor: Picosun Oy, 02150 Espoo (FI)
(72) Inventor: LI, Wei-Min, FI-02260 Espoo (FI)
(74) Representative: Espatent Oy
(86) International application number: PCT/FI2014/050155
(87) International publication number: WO 2015/132445

(56) References cited:
- EP-A1- 2 083 096
- WO-A1-2015/094671
- KR-A- 20100 009 093
- US-A1- 2005 266 700
- US-A1- 2005 266 700
- US-A1- 2011 268 881
- US-A1- 2013 230 975
- US-A1- 2014 065 841

## Description

### FIELD OF THE INVENTION

The present invention relates to depositing germanium with atomic layer deposition (ALD) on substrates.

### BACKGROUND OF THE INVENTION

Atomic Layer Epitaxy (ALE) method was invented by Dr. Tuomo Suntola in the early 1970's. Another generic name for the method is Atomic Layer Deposition (ALD) and it is nowadays used instead of ALE. ALD is a special chemical deposition method based on the sequential introduction of at least two reactive precursor species to at least one substrate.

A basic ALD deposition cycle consists of four sequential steps: pulse A, purge A, pulse B and purge B. Pulse A typically consists of metal precursor vapor and pulse B of nitrogen or oxygen precursor vapor. Inactive gas, such as nitrogen or argon, and a vacuum pump are used for purging gaseous reaction by-products and the residual reactant molecules from the reaction space. A deposition sequence contains at least one deposition cycle. Deposition cycles are repeated until the deposition sequence has produced a thin film of desired thickness.

Precursor species form a chemical bond to reactive sites of the heated surfaces through chemisorption. Reaction conditions are typically arranged in such a way that no more than a molecular or atomic monolayer of a solid material forms on the surfaces during one precursor pulse. Thus, the growth process is self-terminating, i.e. saturative growth. For example, the first precursor can include ligands that remain attached to the adsorbed species and saturate the surface, which prevents further chemisorption. Reaction space temperature is maintained above condensation temperatures and below thermal decomposition temperatures of the utilized precursors such that the precursor molecule species chemisorb on the substrate(s) essentially intact. This chemisorption step is typically followed by a first purge step (purge A) wherein the excess first precursor and possible reaction by-products are removed from the reaction space. Second precursor vapor is then introduced into the reaction space. Second precursor molecules typically react with the adsorbed species of the first precursor molecules, thereby forming the desired thin film material. This growth terminates once the entire amount of the adsorbed first precursor has been consumed. The excess of second precursor vapor and possible reaction by-product vapors are then removed by a second purge step (purge B). The cycle is then repeated until the film has grown to a desired thickness.

Germanium is a promising material for use in semiconductor and optoelectronic devices because it has very high mobility and generally very good transport properties. Compared to silicon or gallium, germanium is much more ordered and has better mobility, making it useful e.g. as a gate oxide in silicon or germanium based transistors.

Despite the great interest of e.g. the semiconductor industry in Ge-deposition, ALD processes for depositing germanium have not been successful. Thus, there still remains a need for industrially applicable methods for depositing germanium and germanium oxide layers on various substrates.

Relevant prior art is known from KR 10-2010-0009093 A.

### SUMMARY

According to a first aspect of the invention there is provided a process of depositing germanium on a substrate, comprising sequentially exposing in at least one deposition cycle and at a temperature selected from the range of 50°C-350°C the substrate inside a chamber with a Ge-containing precursor and a reducing precursor, wherein the Ge-containing precursor is selected from the group consisting of tetrakis(dimethylamino)Ge; germanium beta-diketonates, germanium acetyl acetonates; and the reducing precursor is H2 or hydrogen plasma.

According to certain example embodiments the invention provides a method of depositing elemental germanium (Ge) on substrates, the deposition method comprising sequentially exposing in at least one deposition cycle a substrate inside a deposition chamber with germanium precursor and reducing gas, respectively.

In certain example embodiments the sequential exposure of the substrate comprises running a deposition sequence comprising at least one deposition cycle of Ge precursor pulse; a purge with an inert gas; reducing pulse; and a purge with an inert gas. Accordingly, in certain example embodiments, said at least one deposition cycle comprises:
a. Ge-containing precursor pulse;
b. Purge with an inert gas;
c. Reducing pulse; and
d. Purge with an inert gas.

In certain example embodiments, H₂ is used in step c of the deposition cycle as the reducing pulse in an amount of about 4-100%, preferably about 5-50%, most preferably about 15 % (volume/volume) in a mixture with an inert gas.

The sequential self-saturating surface reactions in ALD produce the desired coating on the substrate inside the deposition chamber. Accordingly, in certain example embodiments, the substrate is coated by using ALD so that essentially all surfaces of the substrate are exposed to the reactants and coated.

The process according to the invention for depositing substrates with germanium can be carried out with the apparatus described in WO 2009/144371.

According to a second aspect of the invention there is provided use of tetrakis(dimethylamino)Ge in atomic layer deposition.

In certain example embodiments, said atomic layer deposition is for depositing on a silicon substrate.

According to a third aspect of the invention there is provided a Ge deposited article manufactured by coating an undeposited article as a substrate by the process according to the first aspect or its embodiments.

Different non-binding example aspects and embodiments of the present invention have been illustrated above. The above embodiments are used merely to explain selected aspects or steps that may be utilized in implementations of the present invention. Some embodiments may be presented only with reference to certain example aspects of the invention.

Accordingly, the following detailed description is not to be taken in a limiting sense, and the scope of the present invention is defined only by the appended claims.

### BRIEF DESCRIPTION OF THE FIGURES

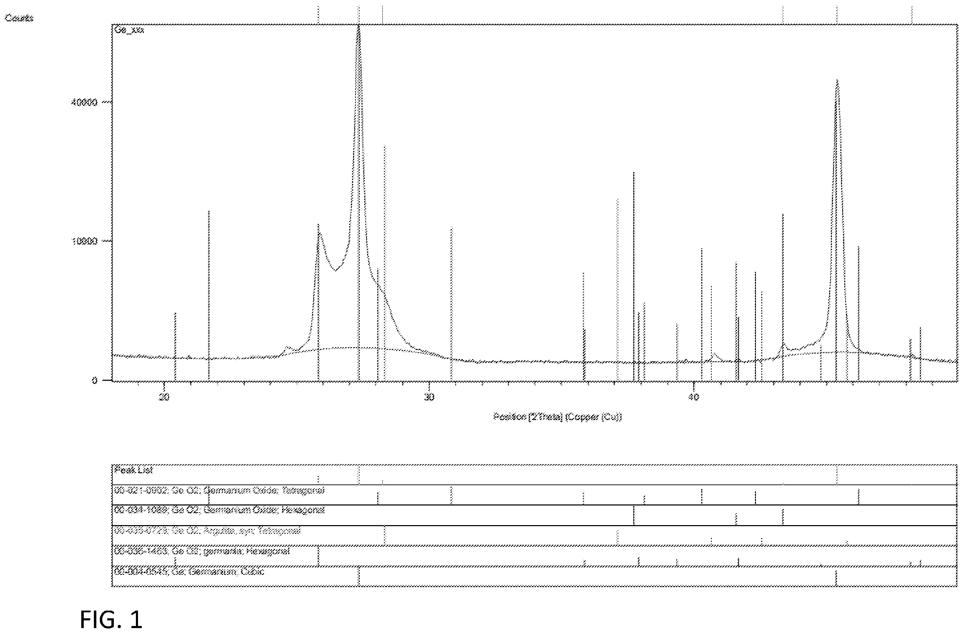

Fig. 1 is an XRD graph providing data on deposition using the deposition method according to the invention.

### DETAILED DESCRIPTION OF THE INVENTION

In the following description, Atomic Layer Deposition (ALD) technology is used to make Ge or GeO₂ coatings on substrates. The basic principles of the ALD deposition are known to a skilled person. As discussed above, ALD is a special chemical deposition method based on the sequential introduction of at least two reactive precursor species to at least one substrate. The method according to the invention is equally applicable to coating more than one substrate of same or different type. The at least one substrate is exposed to temporally separated precursor pulses in a reaction chamber to deposit material on the substrate surfaces by sequential self-saturating surface reactions. In the context of this application, the term ALD comprises all applicable ALD based techniques and any equivalent or closely related technologies, such as, for example MLD (Molecular Layer Deposition) technique.

A basic ALD deposition cycle consists of four sequential steps: pulse A, purge A, pulse B and purge B. Pulse A consists of a first precursor vapor and pulse B of another precursor vapor. Inactive gas and a vacuum pump are typically used for purging gaseous reaction by-products and the residual reactant molecules from the reaction space during purge A and purge B. A deposition sequence comprises at least one deposition cycle. Deposition cycles are repeated until the deposition sequence has produced a thin film or coating of desired thickness.

The ALD process according to certain example embodiments is further illustrated by the following description. Ge or GeO₂ is grown on a substrate from heated Ge precursor and reducing precursor. A heated Ge precursor source is heated to a selected source temperature to create sufficient Ge precursor vapor pressure to be transferrable to the reaction chamber at about 0.1-10 Torr. In some embodiments which use heat-sensitive precursors or substrates it is advantageous to evaporate the precursor at temperatures as low as possible to avoid unnecessary decomposition of precursors or substrates, while still generating a sufficiently big precursor vapor dosage for covering the whole substrate surface. A skilled person is able to adjust the required temperature according to the particular precursor and substrate.

An advantage of volatile precursors at low pressure is that low pressure increases the diffusion speed of gas molecules and helps to recover the equilibrium vapor pressure as fast as possible.

In certain example embodiments, the first precursor is selected from the group consisting of tetrakis(dimethylamino)Ge; beta-diketonates, germanium acetyl acetonates. The second precursor is selected from the group consisting of H₂ and hydrogen plasma.

In certain example embodiments, tetrakis(dimethylamino)Ge, having the chemical formula [(CH₃)₂N]₄Ge, is used in the atomic layer deposition method.

In certain comparative example embodiments, tetrakis(dimethylamino)Ge is used as the first precursor and the second precursor is O₃. The following deposition reaction is obtained:

[(CH₃)₂N]₄Ge + O₃ → GeO₂ + by products

In certain example embodiments, tetrakis(dimethylamino)Ge, having the chemical formula [(CH₃)₂N]₄Ge, is used as the first precursor and the second precursor is H₂.

The following deposition reaction is obtained:

[(CH₃)₂N]₄Ge + H* → Ge + by products

H* refers to radicals, plasma and other energetic species.

The amount of hydrogen as the second precursor in the process may vary. Suitable amounts of H₂ in this respect are 4%-100% based on the volume of hydrogen in an inert carrier gas. The amount of H₂ may be about 4%-90%, about 4%-80%, about 4%-70%, about 4%-60%, about 4%-50%, about 4%-40%, about 4%-30%, about 4%-20%, about 4%-10%, about 10%-90%, about 10%-80%, about 10%-70%, about 10%-60%, about 10%-50%, about 10%-40%, about 10%-30%, or about 10-20%, such as about 95%, 90%, 85%, 80%, 75%, 70%, 65%, 60%, 55%, 50%, 45%, 40%, 35%, 30%, 25%, 20%, 15%, 10%, 5% or 4%. Suitably, the inert carrier gas may be N₂ or Ar. When hydrogen plasma is used, the inert gas is preferably Ar.

The formation of the deposited layer can be verified e.g. by X-ray diffractometry (XRD), X-ray photon spectroscopy (XPS), or X-ray reflection (XRR).

The deposition process may be carried out at a temperature in the range of about 300°C - about 800°C, such as at about 800°C, 750°C, 700°C, 650°C, 600°C, 550°C, 500°C, 450°C, 440°C, 430°C, 420°C, 410°C, 400°C, 390°C, 380°C, 370°C, 360°C, 350°C, 340°C, 330°C, 320°C, 310 or 300°C. Suitably lower temperatures are preferred in which the risk of decomposing the precursor is lower.

### EXAMPLES

The following examples are provided to illustrate various aspects of the present invention. They are not intended to limit the invention, which is defined by the accompanying claims.

### Example 1 - Deposition of elemental germanium

Tetrakis(dimethylamino)germanium and H₂ were used as precursors to deposit Ge on Si substrate.

The following deposition cycle at 350°C was used to run 1000 cycles. Suitable line pressure for precursor source line is 1.3 - 13 hPa (1-10 torr), reaction vessel pressure 1.3 - 13 hPa (1-10 torr), inert carrier gas flow rate 30-300 sccm:
1s [(CH₃)₂N]₄Ge / 2s N₂ / 1s 15% H₂ in N₂ / 1s N₂

As revealed by the XRD analysis shown in Fig 1, Ge film was deposited on the Si substrate. The small amount of Ge oxide seen in the analysis is due to oxidation of the deposited Ge layer caused by oxygen present in the atmosphere.

Instead of tetrakis(dimethylamino)Ge, one or more of the following Ge-containing precursors may be used to deposit Ge or GeO₂ on substrates: germanium beta-deketonates; germanium acetyl acetonates. Suitably, the deposition parameters, such as temperature and, reaction pressure, precursor line pressure are adjusted to be compatible with the particular precursor.

The above deposition method can also be carried out at various temperatures listed above as long as the temperature is below decomposition temperature of the precursors.

### Comparative Example 2 - Deposition of germanium dioxide

Tetrakis(dimethylamino)germanium and O₃ were used as precursors to deposit GeO₂ on a Si substrate.

The following deposition cycle at 350°C was used to run 1000 cycles:
1s [(CH₃)₂N]₄Ge / 2s N₂ / 1s O₃ / 1s N₂

The substrate was coated with a Ge oxide film.

Instead of tetrakis(dimethylamino)Ge one or more of the following Ge-containing precursors may be used: alkyl germanium; alky halide germanium; alkyl germanium; alkyl halide germanium; tetramethyl-Ge, (CH₃)₃GeCl; germanium beta-diketonates; germanium acetyl acetonates: and germanium amidinates.

The above deposition method can also be carried out at various temperatures below decomposition temperature of the precursors.

## Claims

1. A process of depositing elemental germanium on a substrate comprising sequentially exposing in at least one deposition cycle and at a temperature selected from the range of 50°C-350°C the substrate inside a chamber with a Ge-containing precursor and a reducing precursor, wherein the Ge-containing precursor is selected from the group consisting of tetrakis(dimethylamino)Ge; germanium beta-diketonates, germanium acetyl acetonates; and the reducing precursor is H₂ or hydrogen plasma.

2. The process according to claim 1, wherein the at least one deposition cycle comprises:
a. Ge containing precursor pulse;
b. Purge with an inert gas;
c. Reducing pulse; and
d. Purge with an inert gas.

3. The process according to claim 2, wherein at least 4vol% of H₂ is used in the step c. of the deposition cycle as the reducing pulse in a mixture with an inert gas.

4. The process according to any one of claims 2-3, wherein the process is a plasma process and the inert gas is argon.

5. The process according to any one claims 1-4, wherein the Ge-containing precursor has a volatility of at least 1 hPa in a temperature range of from room temperature to 200°C.

6. The process according to any one of claims 1-5, wherein the substrate is a silicon substrate, germanium substrate, III-V semiconductor, silicon oxide, or germanium oxide substrate, or a substrate based on inorganic and organic/polymer materials.

7. The process according to any one of claims 1-6, wherein the process is based on self-saturating surface reactions.

8. The process according to any one of claims 1-7, wherein the deposition cycle is repeated until the deposited layer has a thickness of 10-100 nm.

9. The process of claim 8, wherein said process is an atomic layer deposition process and is for deposition on a silicon substrate when using tetrakis(dimethylamine) germanium as the Ge-containing precursor.

## Patentansprüche

1. Verfahren zum Abscheiden von elementarem Germanium auf einem Substrat, umfassend das sequenzielle Freilegen in mindestens einem Abscheidungszyklus und bei einer Temperatur, die im Bereich von 50 °C bis 350 °C ausgewählt ist, des Substrats in einer Kammer mit einem Ge-haltigen Vorläufer, wobei der Ge-haltige Vorläufer aus der Gruppe bestehend aus Tetrakis(dimethylamino)Ge, Germanium-beta-Diketonaten, Germaniumacetylacetonaten ausgewählt ist; und wobei der reduzierende Vorläufer H₂ oder Wasserstoffplasma ist.

2. Verfahren nach Anspruch 1, wobei der mindestens eine Abscheidungszyklus umfasst:
a. Ge-haltiger Vorläuferimpuls;
b. Spülen mit einem inerten Gas;
c. Reduzierender Impuls; und
d. Spülen mit einem inerten Gas.

3. Verfahren nach Anspruch 2, wobei mindestens 4 Vol.-% H₂ in Schritt c des Abscheidungszyklus als reduzierender Impuls in einer Mischung mit einem inerten Gas verwendet werden.

4. Verfahren nach einem der Ansprüche 2 bis 3, wobei das Verfahren ein Plasmaverfahren ist und das inerte Gas Argon ist.

5. Verfahren nach einem der Ansprüche 1 bis 4, wobei der Ge-haltige Vorläufer eine Flüchtigkeit von mindestens 1 hPa in einem Temperaturbereich von Raumtemperatur bis 200 °C aufweist.

6. Verfahren nach einem der Ansprüche 1 bis 5, wobei das Substrat ein Siliciumsubstrat, Germaniumsubstrat, III-V-Halbleiter, Siliciumoxid oder Germaniumoxidsubstrat oder ein Substrat auf der Grundlage von anorganischen und organischen/Polymermaterialien ist.

7. Verfahren nach einem der Ansprüche 1 bis 6, wobei das Verfahren auf selbstgesättigten Oberflächenreaktionen basiert.

8. Verfahren nach einem der Ansprüche 1 bis 7, wobei der Abscheidungszyklus wiederholt wird, bis die abgeschiedene Schicht eine Dicke von 10 bis 100 nm aufweist.

9. Verfahren nach Anspruch 8, wobei das Verfahren ein Atomlagenabscheidungsverfahren ist und zum Abscheiden auf einem Siliciumsubstrat vorgesehen ist, wenn Tetrakis(dimethylamin)germanium als der Ge-haltige Vorläufer verwendet wird.

## Revendications

1. Procédé de dépôt de germanium élémentaire sur un substrat comprenant l'exposition séquentielle dans au moins un cycle de dépôt et à une température choisie dans la plage de 50 °C à 350 °C le substrat à l'intérieur d'une chambre avec un précurseur contenant du Ge et un précurseur réducteur, le précurseur contenant du Ge étant choisi dans le groupe constitué par le tétrakis(diméthylamino)Ge, ; les béta-dicétonates de germanium, les acétyl acétonates de germanium ; et le précurseur réducteur est H₂ ou un plasma d'hydrogène.

2. Procédé selon la revendication 1, dans lequel l'au moins un cycle de dépôt comprend :
a. une impulsion de précurseur contenant du Ge ;
b. une purge avec un gaz inerte ;
c. la réduction de l'impulsion ; et
d. une purge avec un gaz inerte.

3. Procédé selon la revendication 2, dans lequel au moins 4 % en volume de H₂ est utilisé dans l'étape c. du cycle de dépôt comme l'impulsion réductrice dans un mélange avec un gaz inerte.

4. Procédé selon l'une quelconque des revendications 2 à 3, dans lequel le procédé est un procédé au plasma et le gaz inerte est l'argon.

5. Procédé selon l'une quelconque des revendications 1 à 4, dans lequel le précurseur contenant du Ge a une volatilité d'au moins 1 hPa dans une plage de température de la température ambiante à 200 °C.

6. Procédé selon l'une quelconque des revendications 1 à 5, dans lequel le substrat est un substrat de silicium, un substrat de germanium, un semiconducteur III-V, un oxyde de silicium ou un substrat d'oxyde de germanium ou un substrat sur la base de matériaux inorganiques et organiques/polymère.

7. Procédé selon l'une quelconque des revendications 1 à 6, dans lequel le procédé est basé sur des réactions de surface auto-saturantes.

8. Procédé selon l'une quelconque des revendications 1 à 7, dans lequel le cycle de dépôt est répété jusqu'à ce que la couche déposée ait une épaisseur de 10 à 100 nm.

9. Procédé selon la revendication 8, dans lequel ledit procédé est un procédé de dépôt de couche atomique et est pour le dépôt d'un substrat de silicium quand on utilise du tétrakis (diméthylamine) germanium comme le précurseur contenant du Ge.
